# EUROPÄISCHE PATENTSCHRIFT

(11) **EP 3 425 345 B1**
(45) Veröffentlichungstag und Bekanntmachung des Hinweises auf die Patenterteilung: **21.02.2024**
(21) Anmeldenummer: 18177233.6
(22) Anmeldetag: 12.06.2018
(51) Int. Cl.: G01D 11/24, H01R 13/24

(54) **MESSGERÄT, TRANSMITTERGEHÄUSE UND VERFAHREN ZUR HERSTELLUNG EINES MESSGERÄTS**
MEASURING ELEMENT, TRANSMITTER HOUSING AND METHOD FOR MANUFACTURING A MEASURING ELEMENT
APPAREIL DE MESURE, BOÎTIER ÉMETTEUR ET PROCÉDÉ DE FABRICATION D'UN APPAREIL DE MESURE

(30) Priorität: 07.07.2017 DE 102017115260
(43) Veröffentlichungstag der Anmeldung: 09.01.2019
(73) Patentinhaber: Krohne Messtechnik GmbH, 47058 Duisburg (DE)
(72) Erfinder: Brockhaus, Helmut, 46145 Oberhausen (DE); Matt, Achim, 47055 Duisburg (DE)
(74) Vertreter: Gesthuysen Patentanwälte

(56) Entgegenhaltungen:
- EP-A1- 1 575 344
- DE-A1-102005 046 331
- DE-A1-102012 005 637
- US-A1- 2007 277 604
- US-A1- 2016 381 822
- US-B1- 9 660 380

## Beschreibung

Die Erfindung geht aus von einem Messgerät mit wenigstens einem Sensor und mit wenigstens einem Transmittergehäuse, wobei das Transmittergehäuse wenigstens einen Klemmenraum und einen zum Klemmenraum benachbarten und über eine Trennwand verbundenen Elektronikraum aufweist, wobei in dem Klemmenraum wenigstens eine erste Elektronikeinrichtung für den Anschluss von Versorgungs- und/oder I/O-Leitungen angeordnet ist und wobei in dem Elektronikraum wenigstens eine zweite Elektronikeinrichtung mit Elektronik zur Steuerung des Sensors angeordnet ist, wobei die erste Elektronikeinrichtung und die zweite Elektronikeinrichtung über eine Kontaktierungseinheit miteinander elektrisch leitend verbunden sind, wobei die zweite Elektronikeinrichtung eine Anschlusseinheit aufweist, die mit der Kontaktierungseinheit über eine Steckverbindung verbunden ist, wobei die Steckverbindung eine Fügerichtung aufweist.

Darüber hinaus betrifft die Erfindung ein Transmittergehäuse und ein Verfahren zur Herstellung eines Messgeräts, wobei das Messgerät wenigstens einen Sensor und wenigstens ein Transmittergehäuse aufweist, wobei das Transmittergehäuse wenigstens einen Klemmenraum und einen zum Klemmenraum benachbarten und über eine Trennwand verbundenen Elektronikraum aufweist, wobei in dem Klemmenraum eine erste Elektronikeinrichtung für den Anschluss von Versorgungs- und/oder I/O-Leitungen angeordnet ist und wobei in dem Elektronikraum eine zweite Elektronikeinrichtung mit Elektronik zur Steuerung des Sensors angeordnet ist, wobei die in dem Elektronikraum angeordnete zweite Elektronikeinrichtung eine Anschlusseinheit aufweist, wobei eine Kontaktierungseinheit vorhanden ist, die mit der ersten Elektronikeinrichtung fest verbunden ist, wobei die Kontaktierungseinheit Kontaktelemente in Form von Netzanschlusselementen und/oder Signalkontaktelementen zur Übertragung elektrischer Signale aufweist und wobei die Anschlusseinheit Verbindungselemente in Form von Netzverbindungselementen und/oder Signalverbindungselementen aufweist.

Aus dem Stand der Technik sind Messgeräte bekannt, die neben einer Sensoreinheit zur Aufnahme von physikalischen oder chemischen Messgrößen eine modulare Elektronikeinheit zur Steuerung und zur Versorgung der Sensoreinheit sowie zur Weiterleitung und/oder Auswertung der aufgenommenen Messdaten aufweisen. Üblicherweise ist die Elektronikeinheit in einem Gehäuse angeordnet. Dabei werden in Abhängigkeit vom Einsatzgebiet des Messgeräts, insbesondere der Art der Explosionsgefährdung, unterschiedliche Anforderungen an das Gehäuse und/oder an die Ausgestaltung der Elektronikeinheit gestellt, um die Entstehung und/oder die Ausbreitung einer Explosion zu verhindern.

Folgende Zündschutzarten für elektrische Geräte sind im Rahmen der Erfindung relevant:
"Ex-e" bezeichnet die Anforderung an die Konstruktion von Betriebsmitteln, die einer erhöhten Sicherheit unterliegen. Es werden Maßnahme getroffen, um das Entstehen von Funken in inneren oder äußeren Teilen elektrischer Bauteile zu verhindern. Solche Maßnahmen sind beispielsweise das Überdimensionieren von kritischen Stellen, eine verstärkte Betriebs- und Basisisolation, ein Überlastschutz, ein sicherer Anschluss von ankommenden Leitungen und/oder ein ausreichend mechanischer Schutz.

"Ex-i" bezeichnet die Anforderungen an die Eigensicherheit von Stromkreisen bzw. die Begrenzung der Energie in Stromkreisen. Dies beinhaltet insbesondere, dass ein eigensicherer Stromkreis mit einem ausreichendem Abstand von anderen Stromkreisen getrennt ist. Dabei entspricht der Abstand zwischen zwei Stromkreisen dem kürzesten Weg zwischen diesen Stromkreisen. Unterschieden wird grundsätzlich nach Art des Mediums, durch das der Weg des kürzesten Abstandes führt, so dass sich unterschiedliche Mindestabstände für Luftstrecken, Strecken im Verguss, Abstände durch feste Isolierung, Kriechstrecken in Luft oder Kriechstrecken unter Schutzschicht ergeben.

Zur Bestimmung der einzuhaltenen Mindestabstände wird auf die Normen IEC 60664-1:2007, IEC 61010-1:2010 und IEC 60079-11:2011 verwiesen, deren Inhalt ausdrücklich in die vorliegende Anmeldung einbezogen wird.

"Ex-d" bezeichnet die Anforderung an die Ausgestaltung eines Gehäuse als druckfeste Kapselung, wobei unter dieser Zündschutzart Explosionen im Inneren des Gehäuses zugelassen werden, ihre Auswirkungen auf die Umwelt jedoch durch eine druckfeste Ausgestaltung des Gehäuses verhindert werden sollen.

Im Rahmen der vorliegenden Erfindung wird unterschieden nach Ausgestaltungen, die die Anforderungen zur Gewährleistung eines explosionssicheren Messgeräts erfüllen, und weiterhin nach Ausgestaltungen, die für den Einsatz in einer nicht-explosionsgefährdeten Umgebung geeignet sind.

Eine modulare Elektronikeinheit zur Steuerung und/oder zur Versorgung der Sensoreinheit sowie zur Weiterleitung und/oder Auswertung der aufgenommenen Messdaten umfasst im Rahmen der vorliegenden Erfindung sowohl die Elektronik zum Betreiben des Sensors als auch Anschlüsse für Versorgungs- und/oder I/O - Leitungen, also Input/Output - Leitungen. Üblicherweise sind diese beiden Einheiten in voneinander getrennten Kammern in einem Transmittergehäuse angeordnet.

Im Detail ist die Elektronik zum Betreiben des Sensors in einem Elektronikraum angeordnet. Der Elektronikraum kann weiterhin eine Verbindung zur Sensoreinheit des Messgeräts aufweisen.

Die Anschlüsse für Versorgungs- und/oder I/O-Leitungen sind in einem Klemmenraum angeordnet. Durch die Trennung der beiden Räume kann insbesondere verhindert werden, dass im Elektronikraum entstehende Explosionen sich ungehindert in den Klemmenraum ausbreiten können.

Die im Elektronikraum angeordnete zweite Elektronikeinrichtung und die im Klemmenraum angeordnete erste Elektronikeinrichtung sind in aus dem Stand der Technik bekannten Messgeräten mittels einer Kontaktierungseinheit miteinander verbunden, wobei über die Kontakierungseinheit sowohl Strom als auch elektrische Signale, in Form von Spannungen übertragen werden.

Aus dem Stand der Technik EP 1 575 344 A1 ist ein Steuergerät mit einer Elektronikeinrichtung in Form einer Leiterplatte bekannt, wobei die Leiterplatte als mehrlagige, biegbare, insbesondere starrflexe Leiterplatte ausgestaltet ist.

Die Druckschrift DE 10 2014 117 536 A1 offenbart einen Sensor mit zwei Leiterplatten, wobei die Leiterplatten über Seitenkontaktelemente in einem Winkel miteinander verbunden sind. Dazu weisen die Leiterplatten im Randbereich Kontaktflächen auf, die mit den Seitenkontaktelementen verbunden sind. Die Seitenkontaktelemente weisen zudem eine Biegung auf, sodass die Leiterplatten in einem Winkel zueinander angeordnet sind.

Aus der Druckschrift US 2016/381822 ist ein Messgerät mit einem Transmittergehäuse bekannt, wobei ein Klemmenraum und ein Elektronikraum über eine Trennwand miteinander verbunden sind und wobei die in dem Klemmenraum bzw. Elektronikraum angeordneten Elektronikeinrichtungen über eine Kontaktierungseinheit miteinander elektrisch leitend verbunden sind. Zur besseren Verbindung können die Stecker der Kontaktierungseinheit schwimmend angeordnet sein.

Ausgehend von diesem Stand der Technik liegt der vorliegenden Erfindung die Aufgabe zu Grunde, ein Messgerät und ein Transmittergehäuse anzugeben, das einfach herzustellen ist und dessen Komponenten sich besonders leicht austauschen lassen. Darüber hinaus liegt der Erfindung die Aufgabe zu Grunde, ein Verfahren zur Herstellung eines solchen Messgeräts anzugeben.

Gemäß einer ersten Lehre der vorliegenden Erfindung wird die zuvor genannte Aufgabe durch ein eingangs genanntes Messgerät dadurch gelöst, dass die Anschlusseinheit in Fügerichtung fest angeordnet ist und dass die Anschlusseinheit senkrecht zur Fügerichtung derart schwimmend angeordnet ist, dass sie sich bei bzw. während der Verbindung mit der Kontaktierungseinheit an die Position der Kontaktierungseinheit anpasst. Damit ist die Verbindung als selbstzentrierende Verbindung ausgestaltet.

Erfindungsgemäß wurde erkannt, dass wenn die Anschlusseinheit senkrecht zur Fügerichtung derart schwimmend angeordnet ist, dass sie sich bei, also während dem Prozess des Verbindens mit der Kontaktierungseinheit an die Position der Kontaktierungseinheit anpasst, eine Verbindung zwischen der Kontaktierungseinheit und der Anschlusseinheit besonders leicht herstellen und auch wieder lösen lässt. Insbesondere in engen räumlichen Verhältnissen ist diese Art der Verbindung vorteilhaft.

Gemäß einer ersten Ausgestaltung ist die Anschlusseinheit in einer Halterung schwimmend angeordnet. Dabei ist die Halterung vorzugsweise derart ausgestaltet, dass sie die Anschlusseinheit in Fügerichtung fixiert und weiterhin bezüglich der genauen Position der Anschlusseinheit senkrecht zur Fügerichtung einen ausreichenden Toleranzbereich, vorzugsweise zwischen 0,2 und 0,5 mm, besonders bevorzugt zwischen 0,2 und 0,3 mm, aufweist.

Erfindungsgemäß weist die Anschlusseinheit Verbindungselemente in Form von Netzverbindungselementen und/oder Signalverbindungselementen zur Übertragung elektrischer Signale auf. Die Verbindungselemente sind vorzugsweise paarweise angeordnet.

Gemäß einer Ausgestaltung weisen die Netzverbindungselemente im Vergleich zu den Signalverbindungselementen einen größeren Querschnitt auf.

Die Anschlusseinheit ist vorzugsweise über die Verbindungselemente elektrisch leitend mit der Kontaktierungseinheit verbunden ist. Die Kontaktierungseinheit weist dazu besonders bevorzugt Kontaktelemente in Form von Netzanschlusselementen und/oder Signalkontaktelementen auf, die mit den Verbindungselementen verbunden sind.

Die Verbindungselemente sind erfindungsgemäß zumindest teilweise als trichterförmige Buchsen ausgestaltet. Die Ausgestaltung der Verbindungselemente als trichterförmige Buchsen weist den Vorteil auf, dass als Stifte ausgestaltete Verbindungspartner beim Verbinden der Anschlusseinheit und der Kontaktierungseinheit eingefangen werden können, so dass das Verbinden der Anschlusseinheit und der Kontaktierungseinheit besonders einfach ist. Sind die Verbindungselemente zumindest teilweise als trichterförmige Buchsen ausgestaltet, so weist die Verbindung aus den Buchsen und den mit den Buchsen verbundenen Stiften einen ausreichenden Toleranzbereich, vorzugsweise zwischen 0,2 und 0,5 mm und besonders bevorzugt zwischen 0,2 und 0,3 mm, auf.

Gemäß einer Ausgestaltung weist die Öffnung der trichterförmigen Buchsen einen Durchmesser zwischen 0,2 und 0,5 mm und besonders bevorzugt zwischen 0,2 und 0,3 mm auf, wobei sich der Hals der trichterförmigen Buchsen zumindest abschnittsweise verjüngt.

Gemäß einer weiteren Ausgestaltung sind die Kontaktelemente der Kontaktierungseinheit als entsprechende Verbindungspartner der Verbindungselemente ausgestaltet. Sind die Verbindungselemente als Stifte ausgestaltet, so sind die Kontaktelemente entsprechend als Buchsen, vorzugsweise als trichterförmige Buchsen ausgestaltet. Sind die Verbindungselemente als Buchsen, vorzugsweise als trichterförmige Buchsen ausgestaltet, dann sind die Kontaktelemente als Stifte ausgestaltet.

Vorteilhaft ist es ebenfalls, wenn die Anschlusseinheit zwischen den Netzverbindungselementen und den Signalverbindungselementen und/oder zwischen den Signalverbindungselementen untereinander und/oder zwischen den Netzverbindungselementen untereinander Mittel zur Vergrößerung des Abstandes, im Detail zur Vergrößerung der Kriechstrecken, beispielsweise wenigstens eine Ausnehmung insbesondere wenigstens eine Bohrung und/oder wenigstens einen Schlitz aufweist. Dabei ist die wenigstens eine Bohrung und/oder der wenigstens eine Schlitz vorzugsweise mittels Fräsen in die Anschlusseinheit eingebracht. Die wenigstens eine Bohrung kann kreisförmig ausgestaltet sein und/oder jede andere an die Anwendung angepasste Geometrie aufweisen. Zudem kann der wenigstens eine Schlitz gebogen oder gerade ausgestaltet sein und insbesondere jede an die Anwendung angepasste Geometrie aufweisen. Insbesondere kann auch wenigstens ein Verbindungselement vollständig von einer Ausnehmung umschlossen sein.

Gemäß dieser Ausgestaltung können die zur Gewährleistung eines explosionsgeschützten Bauteils geforderten Trennabstände zwischen den einzelnen Kontaktelementen auch auf engem Raum gewährleistet werden.

Gemäß einer nächsten Ausgestaltung sind die Signalverbindungselemente kreisförmig in wenigstens einem Kreis um wenigstens ein Netzverbindungselement angeordnet.

Durch die kreisförmige Anordnung ist gemäß einer bevorzugten Ausgestaltung gewährleistet, dass bei entsprechend gewähltem Radius des Kreises sämtliche Signalverbindungselemente den erforderlichen Mindestabstand zu dem wenigstens einen Netzverbindungselement zur Gewährleistung einer Explosionssicherheit einhalten.

Daneben ist es ebenfalls denkbar und vorteilhaft, wenn die Signalverbindungselemente in einer anderen geometrischen Form um wenigstens ein Netzverbindungselement angeordnet sind.

Besonders bevorzugt sind die Signalverbindungselemente in wenigstens zwei Kreisen mit unterschiedlichem Radius bzw. Abstand zu dem wenigstens einen Netzverbindungselement angeordnet. Dabei weisen vorzugsweise sämtliche Signalverbindungselemente den erforderlichen Mindestabstand zur Gewährleistung einer Explosionssicherheit zu den Netzverbindungselementen auf.

Beispielsweise kann weiterhin vorgesehen sein, dass wenigstens ein Abstand zwischen wenigstens einem Signalverbindungselement und einem Netzverbindungselement und/oder wenigstens ein Abstand zwischen zwei Signalverbindungselementen den erforderlichen Mindestabstand zur Gewährleistung des Explosionsschutzes unterschreitet. Zwar kann eine solche Ausgestaltung nur in einer nicht explosionsgefährdeten Umgebung eingesetzt werden, jedoch weist diese Ausgestaltung den Vorteil auf, dass besonders viele Verbindungselemente auf begrenztem Raum zur Signalübertragung zur Verfügung stehen. Beispielsweise können so auch Gigabit-Ethernet-Verbindungen auf engem Raum realisiert werden.

Gemäß einer Ausgestaltung weist die Anschlussseinheit wenigstens 15 Kontaktelemente auf. Gemäß einer nächsten Ausgestaltung weist die Anschlusseinheit wenigstens 22 Kontaktelemente auf.

Gemäß einer nächsten vorteilhaften Ausgestaltung sind die Signalverbindungselemente zu wenigstens einer Schaltkreisgruppe zusammengefasst, wobei die wenigstens eine Schaltkreisgruppe wenigstens zwei Signalverbindungselemente aufweist. Diese Ausgestaltung weist den Vorteil auf, dass zusammengehörige Leiterbahnen in oder auf der zweiten Elektronikeinrichtung eng nebeneinander geführt werden können. Besonders bevorzugt sind wenigstens zwei räumlich voneinander getrennte Schaltkreisgruppen vorhanden. Dabei entspricht der Abstand zwischen den Schaltkreisgruppen, also der geringste Abstand zwischen den Signalverbindungselementen der unterschiedlichen Schaltkreisgruppen, wenigstens dem normierten Mindestabstand zur Gewährleistung einer Explosionssicherheit.

Gemäß einer weiteren Ausgestaltung ist die Anschlusseinheit derart ausgestaltet, dass innerhalb wenigstens einer Schaltkreisgruppe oder zwischen wenigstens zwei Schaltkreisgruppen wenigstens ein Abstand zwischen zwei Signalverbindungselementen den normierten Mindestabstand zur Einhaltung der Luft- und/oder Kriechfestigkeit unterschreitet. Diese Ausgestaltung ist nur für den Einsatz in nicht-explosionsgefährdeter Umgebung geeignet, weist aber den Vorteil auf, dass auf besonders engem Raum viele Verbindungselemente zur Verfügung gestellt werden können.

Gemäß einer nächsten Ausgestaltung ist die Anschlusseinheit zum Schutz des Anwenders und/oder zur Verbesserung der Trennung zu den weiteren im Elektronikraum angeordneten Elektronikbauteilen mit einem Isolierstoff abgedeckt.

Gemäß einer Ausgestaltung ist die Isoliation als Kappe ausgestaltet, die über eine Rastverbindung mit der Anschlusseinheit verbunden ist.

Gemäß einer vorteilhaften Ausgestaltung umfasst die erste Elektronikeinrichtung eine erste Leiterplatte und/oder die zweite Elektronikeinrichtung umfasst eine zweite Leiterplatte.

Besonders bevorzugt ist die Form der ersten Elektronikeinrichtung zumindest teilweise an die innere Form des Klemmenraums und/oder die Form der zweiten Elektronikeinrichtung ist zumindest teilweise an die innere Form des Elektronikraums angepasst. Weist das Transmittergehäuse zumindest im Bereich des Klemmenraums und/oder des Elektronikraums einen kreisförmigen Querschnitt auf, so weist bzw. weisen vorzugsweise auch die erste und/oder die zweite Elektronikeinrichtung die Form eines Kreises oder eines Kreisabschnittes, insbesondere eines Halbkreises auf.

Erfindungsgemäß ist die zweite Elektronikeinrichtung als zumindest teilweise biegbare Leiterplatte ausgestaltet. Beispielsweise kann die Leiterplatte als Flex-Leiterplatte oder als starrflexe Leiterplatte oder als semiflexe Leiterplatte oder als Twinflex-Leiterplatte ausgestaltet sein. Besonders bevorzugt weist die Leiterplatte wenigstens zwei starre Leiterplattenteile und wenigstens einen biegbaren Teil auf, der die wenigstens zwei starren Leiterplattenteile miteinander verbindet. Besonders bevorzugt ist die Anschlusseinheit als ein starrer Teil der biegbaren Leiterplatte ausgestaltet und wenigstens ein starrer Teil ist als Aufnahmeeinheit für die im Elektronikraum angeordnete Elektronik ausgestaltet. Weiterhin ist es vorteilhaft, wenn die wenigstens zwei starren Teile der biegbaren Leiterplatte einen Winkel, vorzugsweise einen Winkel zwischen 90° und 180° oder zwischen 90° und 160°oder einen 90°-Winkel oder einen Winkel zwischen 45° und 90° einschließen. Insgesamt kann das Transmittergehäuse damit besonders kompakt ausgestaltet sein.

Gemäß einer weiteren besonders bevorzugten Ausgestaltung umfasst die biegbare Leiterplatte innenliegende Leiterbahnen. An die Abstände zwischen innenliegenden Leiterbahnen werden zur Gewährleistung eines Explosionsschutzes geringere Anforderungen gestellt. Insofern kann ein explosionssicheres Messgerät bereitgestellt werden, das gleichzeitig eine hohe Anzahl an Signalübertragungselementen auf engem Raum bereitstellt.

Die im Elektronikraum angeordnete Elektronik zur Steuerung des Sensors ist vorzugsweise als kompakter Geräteeinsatz, ausgestaltet, der über Steckverbindungen mit der zweiten Elektronikeinrichtung verbunden ist. Ein kompakter Geräteinsatz kann beispielsweise gestapelte bestückte Leiterplatten umfassen, die mittels einer Steckverbindung mit der zweiten Elektronikeinrichtung verbunden sind. Diese Ausgestaltung weist den Vorteil auf, dass die gesamte Elektronik als Baugruppe besonders leicht austauschbar ist.

Gemäß einer weiteren Ausgestaltung ist die zweite Elektronikeinrichtung lösbar, beispielsweise durch eine Schraubverbindung mit dem Transmittergehäuse verbunden. Weiterhin ist vorzugsweise eine sichere Verbindung zwischen der zweiten Elektronikeinrichtung und dem Transmittergehäuse vorhanden. Eine sichere Verbindung wird vorzugsweise durch eine leitende Verbindung des Massepotentials der zweiten Elektronikeinrichtung zum Transmittergehäuse realisiert.

Gemäß einer nächsten Ausgestaltung weist die erste Elektronikeinrichtung vorzugsweise wenigstens ein Anschlusselement, zur Kontaktierung des Netzanschlusses und wenigstens ein Anschlusselement zur Kontaktierung der Signalübertragungselemente auf. Die zuvor genannten Anschlusselemente sind vorzugsweise als Klemmen ausgestaltet.

Gemäß einer weiteren Ausgestaltung sind die erste Elektronikeinrichtung und der Klemmenraum derart ausgestaltet, dass die im Betrieb des Messgeräts zu den Anschlusselementen laufenden Verbindungskabel im Klemmenraum durch ausreichend Platz mechanisch stabilisiert werden können.

Gemäß einer weiteren vorteilhaften Ausgestaltung ist bzw. sind die erste Elektronikeinrichtung und/oder die Anschlusselemente beispielsweise in Form von Klemmen zumindest teilweise mit einem Isolierstoff bedeckt. Damit kann gewährleistet werden, dass auch wenn der Anwender den Klemmenraum öffnet, ein ausreichender Schutz zu den elektronischen Anschlüssen besteht.

Gemäß einer weiteren vorteilhaften Ausgestaltung ist die Kontaktierungseinheit als elektrisches Durchführungselement ausgestaltet, vorzugsweise als Stopfen mit eingeglasten oder in Kunststoff eingegossenen Kontaktelementen, insbesondere wobei der Stopfen in einen Metallzylinder eingefasst ist. Ein Glas/Metall-Durchführungselement ist in vorteilhafter Weise geeignet für den Einsatz in explosionsgefährderter Umgebung. Ein Durchführungselement aus Kunststoff ist geeignet für den Einsatz in nicht explosionsgefährderter Umgebung.

Gemäß einer nächsten vorteilhaften Ausgestaltung weist die Kontaktierungseinheit die Kontaktelemente in Form von Netzanschlusselementen und/oder Signalkontaktelementen zur Übertragung elektrischer Signale auf. Die Kontaktelemente können als Stifte oder auch als Buchsen ausgestaltet sein.

Vorteilhaft ist es, wenn die Netzanschlusselemente und/oder die Signalkontaktelemente stoffschlüssig mit der ersten Elektronikeinrichtung verbunden sind. Beispielsweise können die Kontaktelemente mit der ersten Elektronikeinrichtung verlötet sein.

Vorteilhaft ist es weiterhin, wenn die Kontaktelemente innerhalb eines Schutzkragens angeordnet sind, wodurch die Zündschutzsicherheit des Messgeräts erhöht werden kann.

Besonders bevorzugt ist das Kontaktierungselement lösbar in die Ausnehmung der Trennwand eingesetzt.

Gemäß einer bevorzugten Ausgestaltung ist die erste Elektronikeinrichtung lösbar über wenigstens ein Befestigungsmittel mit dem Transmittergehäuse verbunden. Beispielsweise ist die erste Elektronikeinrichtung mit dem Transmittergehäuse verschraubt. Vorzugsweise ist wenigstens eine Schraube oder ein anderes Befestigungsmittel oder wenigstens zwei Schrauben oder zwei andere Befestigungsmittel unmittelbar neben der Kontaktierungseinheit angeordnet, um die Kontaktierungseinheit stabilisierend zu halten. Dabei liegen die Schrauben bzw. die anderen Befestigungsmittel unmittelbar an der Kontaktierungseinheit an und/oder berühren die Kontaktierungseinheit. Darüber hinaus ist vorzugsweise wenigstens eine Verbindung zwischen der ersten Elektronikeinrichtung und dem Transmittergehäuse als sichere Verbindung zum Gehäuse ausgestaltet. Dazu ist vorzugsweise die erste Elektronikeinrichtung, insbesondere das Massepotential der ersten Elektronikeinrichtung, elektrisch leitend mit dem Transmittergehäuse verbunden.

Grundsätzlich kann das Transmittergehäuse derart ausgestaltet sein, dass der Elektronikraum bzw. die im Elektronikraum angeordneten Elemente und der Klemmenraum bzw. die im Klemmenraum angeordneten Elemente die Anforderungen von gleichen Zündschutzklassen oder unterschiedlicher Zündschutzklassen erfüllen.

Beispielsweise können sowohl der Elektronikraum als auch der Klemmenraum die Anforderungen bezüglich des Berührschutzes und der elektromagnetischen Verträglichkeit erfüllen ohne für die Anwendung in explosionsgefährdeter Umgebung geeignet zu sein.

Zudem können sowohl der Elektronikraum als auch der Klemmenraum die Anforderungen bezüglich des Berührschutzes und der elektromagnetischen Verträglichkeit erfüllen, wobei der Elektronikraum zusätzlich druckfest gekapselt ist (Ex-d) und der Klemmenraum die Anforderungen einer erhöhten Sicherheit erfüllt (Ex-e).

Weiterhin können sowohl der Elektronikraum als auch der Klemmenraum die Anforderungen bezüglich des Berührschutzes und der elektromagnetischen Verträglichkeit erfüllen, wobei der Elektronikraum zusätzlich druckfest gekapselt ist (Ex-d) und eine sichere Trennung zwischen Ex-e-Signalen (Netzspannung) und Ex-i-Signalen (I/O-Anschluss) gewährleistet ist. Darüber hinaus können sowohl der Elektronikraum als auch der Klemmenraum die Anforderungen bezüglich des Berührschutzes und der elektromagnetischen Verträglichkeit und zusätzlich einer druckfesten Kapselung (Exd) erfüllen.

Schließlich können sowohl der Elektronikraum als auch der Klemmenraum die Anforderungen bezüglich des Berührschutzes und der elektromagnetischen Verträglichkeit und zusätzlich einer druckfesten Kapselung (Ex-d) erfüllen, wobei die Kontaktierungseinheit nicht druckfest ausgestaltet ist.

Gemäß einer zweiten Lehre der vorliegenden Erfindung wird die eingangs hergeleitete Aufgabe durch ein Transmittergehäuse gelöst, wobei das Transmittergehäuse wenigstens einen Klemmenraum und einen zum Klemmenraum benachbarten und über eine Trennwand verbundenen Elektronikraum aufweist, wobei in dem Klemmenraum wenigstens eine erste Elektronikeinrichtung für den Anschluss von Versorgungs- und/oder I/O-Leitungen angeordnet ist und wobei in dem Elektronikraum wenigstens eine zweite Elektronikeinrichtung mit Elektronik zur Steuerung des Sensors angeordnet ist, wobei die erste Elektronikeinrichtung und die zweite Elektronikeinrichtung über eine Kontaktierungseinheit miteinander elektrisch leitend verbunden sind,
wobei die zweite Elektronikeinrichtung eine Anschlusseinheit aufweist, die mit der Kontaktierungseinheit über eine Steckverbindung verbunden ist, wobei die Steckverbindung eine Fügerichtung aufweist. Das Transmittergehäuse zeichnet sich dadurch aus, dass die Anschlusseinheit in Fügerichtung fest angeordnet ist und dass die Anschlusseinheit senkrecht zur Fügerichtung derart schwimmend angeordnet ist, dass sie sich bei der Verbindung mit der Kontaktierungseinheit an die Position der Kontaktierungseinheit anpasst und
dass das Transmittergehäuse für die Verwendung in einem der zuvor beschriebenen Messgeräte ausgestaltet ist.

Gemäß einer nächsten Lehre der vorliegenden Erfindung wird die eingangs hergeleitete Aufgabe durch ein eingangs genanntes Verfahren zur Herstellung eines Messgeräts, dadurch gelöst, dass das Verfahren die folgenden Schritte umfasst:
- Montieren der zweiten Elektronikeinrichtung in dem Elektronikraum, wobei die Anschlusseinheit schwimmend angeordnet wird,
- Montieren der ersten Elektronikeinrichtung in dem Klemmenraum, wobei die Kontaktierungseinheit lösbar in die Trennwand eingesetzt wird,
- wobei durch das Montieren der ersten Elektronikeinrichtung die Kontaktierungseinheit mit der Anschlusseinheit verbunden wird,
- wobei die Anschlusseinheit sich selbstzentrierend an die Position der Kontaktierungseinheit anpasst.

Das erfindungsgemäße Verfahren weist auf Grund der selbstzentrierenden Verbindung zwischen der Anschlusseinheit und dem Verbindungselement den Vorteil auf, dass die Montage eines solchen Messgeräts besonders einfach ist.

Das auf diese Weise hergestellte Messgerät ist vorzugsweise gemäß einer der zuvor beschriebenen Ausgestaltungen ausgestaltet.

Im Einzelnen gibt es nun eine Vielzahl von Möglichkeiten, das erfindungsgemäße Messgerät, das Transmittergehäuse und das erfindungsgemäße Verfahren auszugestalten und weiterzubilden. Dazu wird verwiesen sowohl auf die den unabhängigen Patentansprüchen nachgeordneten Patentansprüche als auch auf die nachfolgende Beschreibung von bevorzugten Ausführungsbeispielen in Verbindung mit der Zeichnung. In der Zeichnung zeigen
- Fig. 1: ein erstes Ausführungsbeispiel eines Messgeräts,
- Fig. 2: ein erstes Ausführungsbeispiel eines Elektronik-Geräteeinsatzes,
- Fig. 3: ein erstes Ausführungsbeispiel einer zweiten Elektronikeinrichtung,
- Fig. 4: das erste Ausführungsbeispiel einer zweiten Elektronikeinrichtung,
- Fig. 5: das erste Ausführungsbeispiel einer zweiten Elektronikeinrichtung,
- Fig. 6: ein Ausführungsbeispiel einer Anschlusseinheit,
- Fig. 7: ein Aufbau einer zweiten Elektronikeinrichtung
- Fig. 8: ein erstes Ausführungsbeispiel einer ersten Elektronikeinrichtung,
- Fig. 9: das erste Ausführungsbeispiel einer ersten Elektronikeinrichtung in rückseitiger Ansicht,
- Fig. 10: ein zweites Ausführungsbeispiel einer ersten Elektronikeinrichtung und
- Fig. 11: ein erstes Ausführungsbeispiel eines erfindungsgemäßen Verfahrens

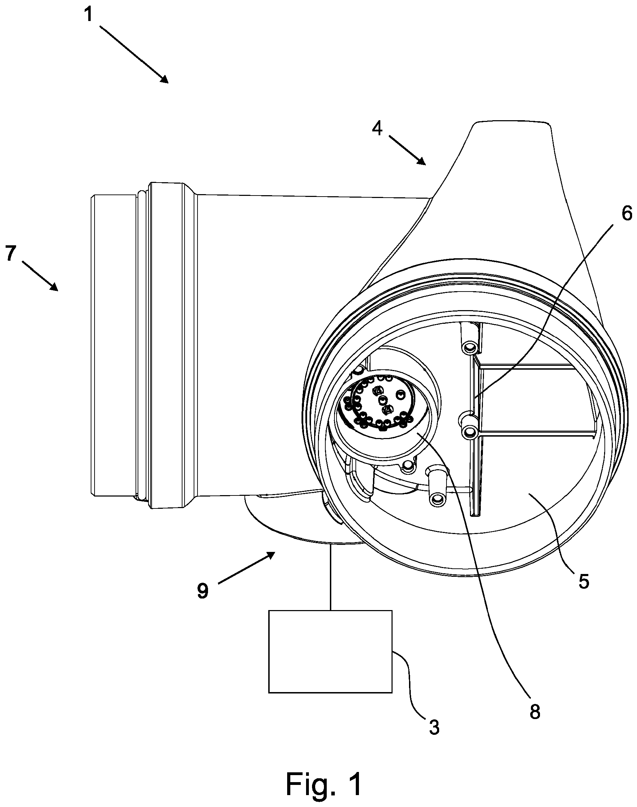

Fig. 1 zeigt eine Darstellung eines Messgeräts 1 mit einem Sensor 3 zur Aufnahme einer physikalischen Messgröße und mit einem Transmittergehäuse 4. Das Transmittergehäuse 4 umfasst einen Klemmenraum 5 und einen zum Klemmenraum 5 benachbarten und über eine Trennwand 6 verbundenen Elektronikraum 7, wobei in dem dargestellten Klemmenraum 5 keine Elektronikeinrichtung angeordnet ist. Die Trennwand 6 weist eine Ausnehmung 8 zur Aufnahme einer Kontaktierungseinheit auf. Zudem weist der Elektronikraum 7 einen Anschlussbereich 9 auf, durch den die in dem Elektronikraum angeordnete zweite Elektronikeinrichtung mit dem Sensor 3 verbunden ist.

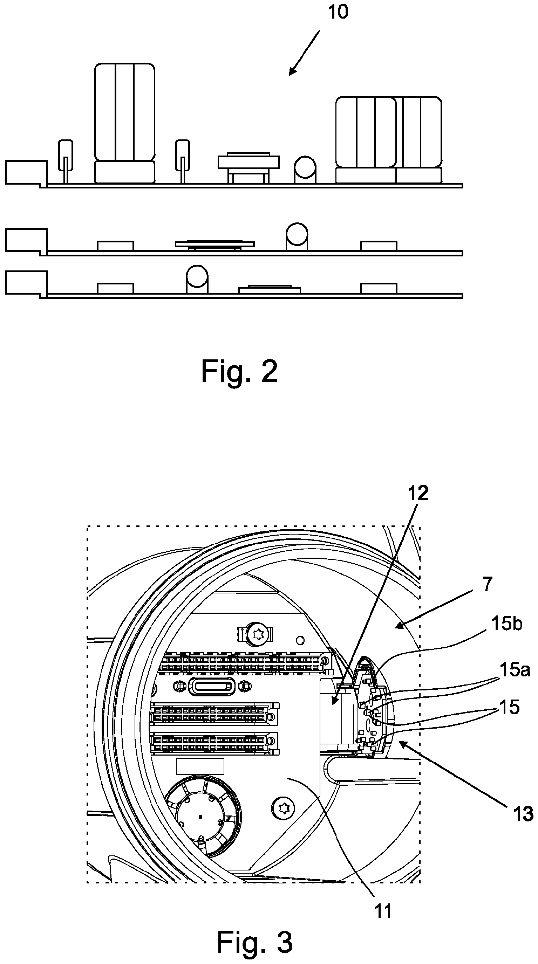

In Fig. 2 ist ein Ausführungsbeispiel eines Elektronikeinsatzes 10 dargestellt, wobei die dargestellten Elektronikbauteile zur Steuerung des Sensors 3 ausgestaltet sind. Der Elektronikeinsatz 10 ist als Bauteil bzw. als Baueinheit ausgestaltet, das bzw. die besonders leicht insbesondere über eine Steckverbindung eingebaut und ausgetauscht werden kann.

Fig. 3 zeigt ein erstes Ausführungsbeispiel einer zweiten Elektronikeinrichtung 11, die in einem Elektronikraum 7 angeordnet ist. Die Elektronikeinrichtung 11 ist als starrflexe Leiterplatte mit zwei starren Leiterplattenteilen ausgestaltet. Auf einem ersten starren Leiterplattenteil sind Steckplätze zur Aufnahme eines Elektronikeinsatzes 10 angeordnet. Der zweite starre Leiterplattenteil ist als Anschlusseinheit 13 für die Verbindung mit einer Kontaktierungseinheit 14 ausgestaltet. Zwischen den beiden starren Leiterplattenteilen ist eine flexible Verbindung 12 angeordnet, wobei insbesondere die Leiterbahnen der starrflexen Leiterplatte eine durchgehende Verbindung der beiden starren Leiterplattenteile und der flexiblen Verbindung darstellen.

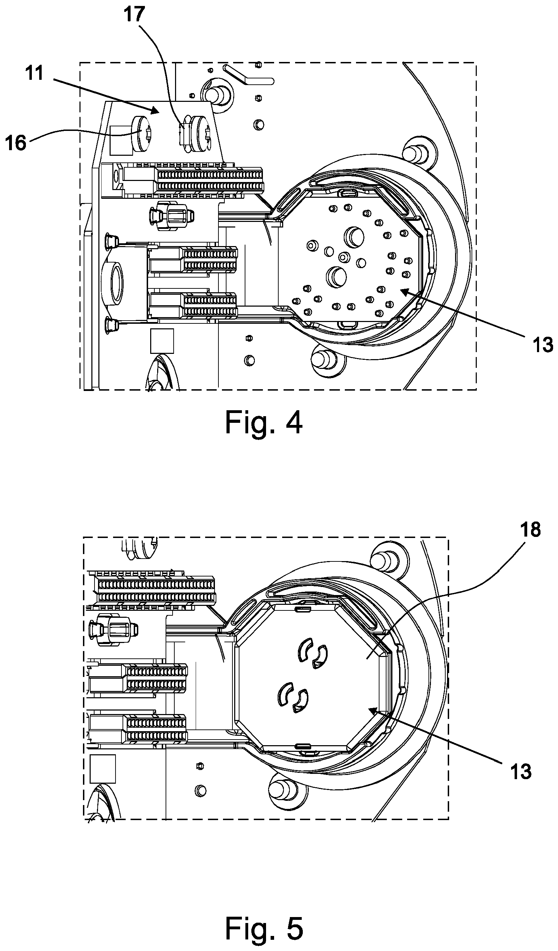

Die Anschlusseinheit 13 weist Verbindungselemente 15 in Form von Netzverbindungselementen 15a und Signalverbindungselementen 15b auf, wobei die Signalverbindungselemente 15b, wie auch in Fig. 4 dargestellt, in zwei Kreisen um die Netzverbindungselemente 15a angeordnet sind.

Die Verbindungselemente 15 sind derart ausgestaltet, dass sie mit der Kontaktierungseinheit 14 elektrisch leitend mittels einer Steckverbindung verbunden werden können. Die Verbindungselemente 15 sind dazu trichterförmig ausgestaltet und können stiftartige Kontaktelemente während dem Prozess des Verbindens einfangen und zentrieren.

Die Anschlusseinheit 13 ist senkrecht zur Fügerichtung der Verbindung zwischen der Anschlusseinheit 13 und der Kontaktierungseinheit 14 schwimmend in einer Halterung angeordnet und kann sich so bei der Verbindung mit der Kontaktierungseinheit 14 an die Position der Kontaktierungseinheit 14 anpassen. Insgesamt ist die Verbindung zwischen den Verbindungselementen 15 und der Kontaktierungseinheit 14 damit selbstzentrierend ausgestaltet.

Fig. 4 zeigt eine weitere Ansicht des in Fig. 3 dargestellten Ausführungsbeispiels einer zweiten Elektronikeinrichtung 11. Die Leiterplatte ist über eine Schraubverbindung 16 mit dem Transmittergehäuse 4 verbunden. Eine Schraubverbindung 16 ist als sichere Verbindung 17 ausgestaltet, über die das Massepotential der Leiterplatte mit dem Gehäuse 4 verbunden ist. Die Anschlusseinheit 13 weist Netzverbindungselemente 15a und Signalverbindungselemente 15b auf, die in zwei Kreisen um die Netzverbindungselemente 15a angeordnet sind. Dabei entspricht der Abstand der Signalverbindungselemente 15b zu den Netzverbindungselementen 15a dem normierten Mindestabstand zur Einhaltung der Luft- und Kriechfestigkeit.

Die Signalverbindungselemente 15b sind paarweise angeordnet. Dabei unterschreitet der Abstand zwischen den in dem äußeren Kreis angeordneten Signalverbindungselementen 15b und den in dem inneren Kreis angeordneten Signalverbindungselementen 15b zumindest teilweise den normierten Mindestabstand zur Einhaltung der Luft- und Kriechfestigkeit. Damit eignet sich die in Fig. 4 dargestellte zweite Elektronikeinrichtung 11 nur für den Einsatz in nicht explosionsgefährdeter Umgebung. Gemäß einem anderen Ausführungsbeispiel wird der Mindestabstand zur Gewährleistung einer Luft- und Kriechfestigkeit zwischen sämtlichen Signalverbindungselementen 15b und Netzverbindungselementen 15a eingehalten. Eine solche Ausführung ist ebenfalls für den Einsatz in explosionsgefährdeter Umgebung geeignet.

In Fig. 5 ist ein Ausführungsbeispiel einer Anschlusseinheit 13 dargestellt, die mit einem Isolierstoff 18 abgedeckt. Der Isolierstoff 18 ist als Kappe ausgestaltet, die über eine Rastverbindung mit der Anschlusseinheit 13 verbunden ist. Das dargestellte Ausführungsbeispiel weist eine erhöhte Sicherheit insbesondere beim Öffnen des Transmittergehäuses 4 auf

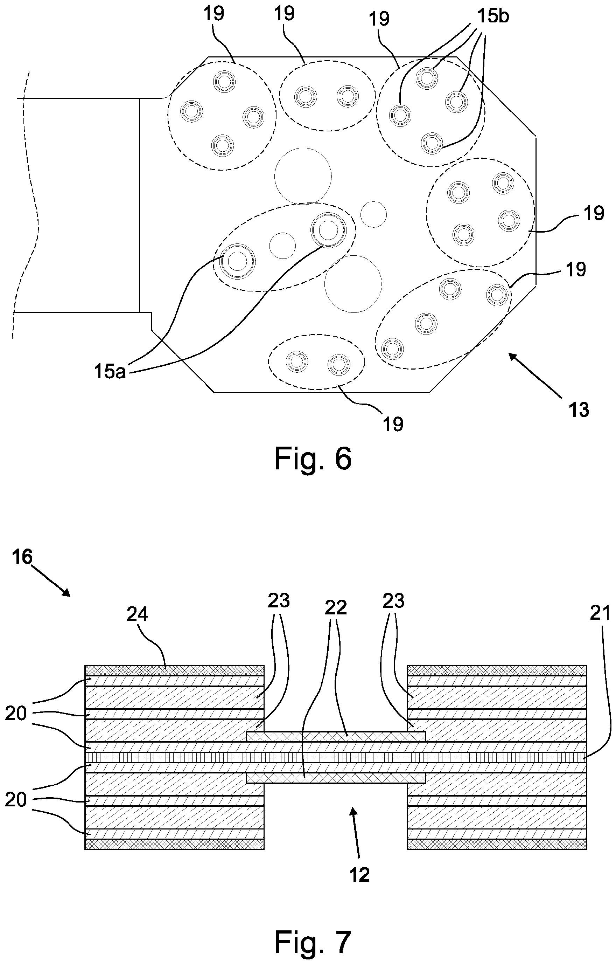

Fig. 6 zeigt ebenfalls ein Ausführungsbeispiel einer Anschlusseinheit 13 mit Netzverbindungselementen 15a und Signalverbindungselementen 15b, wobei die Signalverbindungselemente 15b kreisförmig um die Netzverbindungselemente 15a angeordnet sind. Die Signalverbindungselemente 15b sind zu Schaltkreisgruppen 19 zusammengefasst, sodass in vorteilhafter Weise zusammengehörige Leiterbahnen eng nebeneinander geführt werden können.

Fig. 7 zeigt den Aufbau einer Ausgestaltung der in dem Elektronikraum 7 angeordneten starrflexen Leiterplatte. Die Leiterplatte ist als Mehrlagenflexleiterplatte mit innenliegenden Leiterbahnen ausgestaltet. Im dargestellten Ausführungsbeispiel weisen die starren Leiterplattenteile jeweils sechs übereinander angeordnete Metalllisierungsschichten 20 auf. Der flexible Teil 12 der starrflexen Leiterplatte weist zwei Metallsierungsschichten 20 auf, die jeweils mit Isolierstoff abgedeckt sind. Innenliegend ist eine Folie 21 aus Flex Polyimid mit einer Dicke von ca 50 µm angeordnet, durch die die flexible Teil 12 der Leiterplatte biegbar ist. Der flexible Teil 12 der starrflexen Leiterplatte ist weiterhin durch eine Polyimid Schutzschicht 22, die eine Dicke zwischen 25 und 50 µm aufweist, bedeckt. Weiterhin weist die Leiterplatte Zwischenschichten 23 aus vorimprägnierten Faserwerkstoff auf, die jeweils eine Dicke zwischen 250 µm und 600 µm aufweisen. Der starre Teil der Leiterplatte weist eine Lötabdeckung 24 auf.

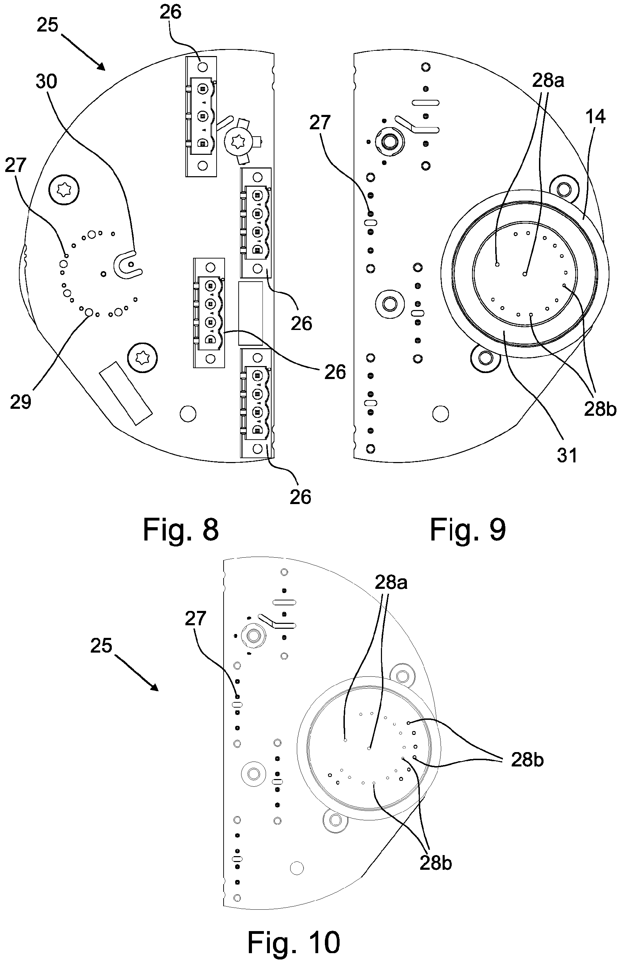

Die Fig. 8 und 9 zeigen ein erstes Ausführungsbeispiel einer ersten Elektronikeinrichtung 25 in Form einer Leiterplatte, die im Betriebszustand im Klemmenraum 5 angeordnet ist. Die Leiterplatte ist halbkreisförmig ausgestaltet und ist in ihrer Form an die Form des inneren Querschnittes des Klemmenraums 5 angepasst. Auf der Leiterplatte sind Klemmen für den Anschluss von Versorgungs- und I/O-Leitungen angeordnet. Zudem sind Durchkontaktierungen 27 vorhanden, die mit den Kontaktelementen 28 der Kontaktierungseinheit 14, wie nachfolgend dargestellt, fest verbunden sind. Im dargestellten Ausführungsbeispiel sind die Kontaktelemente 28 mit den Durchkontaktierungen 27 verlötet. Insofern kann die Leiterplatte und die Kontaktierungseinheit 14 als Baugruppe gehandhabt werden und insbesondere als Einheit montiert und auch ausgetauscht werden. Zur Vergrößerung des Abstandes zwischen den Durchkontaktierungen 27 bzw. den Kontaktelementen 28 sind in der Leiterplatte kreisförmige Bohrungen 29 und ein gebogener Schlitz 30 vorhanden.

Fig. 9 zeigt die in Fig. 8 dargestellte Leiterplatte in rückseitiger Ansicht. Die Darstellung zeigt die Seite der Leiterplatte, die im Betriebszustand dem Elektronikraum 7 zugewandt ist. Neben den Durchkontaktierungen 27 für den Anschluss über die Klemmen 26 ist eine Kontaktierungseinheit 14 in Form eines elektrischen Durchführungselementes mit Kontaktelementen 28 in Form von Netzanschlusselementen 28a und Signalkontaktelementen 28b vorhanden. Die Signalkontaktelemente 28b sind derartig kreisförmig um die Netzanschlusselemente 28a angeordnet, dass der Abstand zwischen den Netzanschlusselementen 28a und den Signalkontaktelementen 28b dem normierten Mindestabstand zur Einhaltung der Luft- und Kriechfestigkeit entspricht. Die Anforderungen an den Abstand zwischen den Signalkontaktelementen 28b untereinander sind geringer. In dem dargestellten Ausführungsbeispiel sind auch die Abstände zwischen den Signalkontaktelementen 28b derart bemessen, dass die Leiterplatte für den Einsatz in explosionsgefährdeter Umgebung geeignet ist. Darüber hinaus weist das Durchführungselement einen Schutzkragen 31 auf, der die Zündschutzsicherheit erhöht.

Fig. 10 zeigt ein zweites Ausführungsbeispiel einer ersten Elektronikeinrichtung 25 in Form einer Leiterplatte, die im Betriebszustand im Klemmenraum 5 angeordnet ist. Im Unterschied zu dem in den Fig. 8 und 9 dargestellten Ausführungbeispiel sind die Signalkontaktelemente 28b kreisförmig in zwei Kreisen um die Netzanschlusselemente 28a angeordnet. In vorteilhafter Weise werden mit diesem Ausführungsbeispiel besonders viele Übertragungselemente zu Verfügung gestellt.

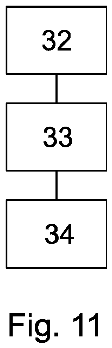

In Fig. 11 ist ein Verfahren 2 zur Herstellung eines Messgeräts 1 dargestellt, wobei das Messgerät 1 einen Sensor 3 und ein Transmittergehäuse 4 aufweist, wobei das Transmittergehäuse 4 einen Klemmenraum 5 und einen zum Klemmenraum 5 benachbarten und über eine Trennwand 6 verbundenen Elektronikraum 7 aufweist, wobei in dem Klemmenraum 5 eine erste Elektronikeinrichtung 25 für den Anschluss von Versorgungs- und/oder I/O-Leitungen angeordnet ist und wobei in dem Elektronikraum 7 eine zweite Elektronikeinrichtung 11 mit Elektronik zur Steuerung des Sensors 3 angeordnet ist, wobei die in dem Elektronikraum 7 angeordnete zweite Elektronikeinrichtung 11 eine Anschlusseinheit 13 aufweist, wobei eine Kontaktierungseinheit 14 in Form eines elektrischen Durchführungselementes vorhanden ist, die mit der ersten Elektronikeinrichtung 25 fest verbunden ist, wobei die Kontaktierungseinheit 14 Kontaktelemente 28 in Form von Netzanschlusselementen 28a und/oder Signalkontaktelementen 28b zur Übertragung elektrischer Signale aufweist und
wobei die Anschlusseinheit 13 Verbindungselemente 15 in Form von Netzverbindungselementen 15a und/oder Signalverbindungselementen 15b aufweist.

Das Verfahren 2 umfasst die folgenden Schritte:
- Montieren 32 der zweiten Elektronikeinrichtung 11 in dem Elektronikraum 7, wobei die Anschlusseinheit 13 schwimmend angeordnet wird,
- Montieren 33 der ersten Elektronikeinrichtung 25 in dem Klemmenraum 5, wobei die Kontaktierungseinheit 14 lösbar in die Trennwand 6 eingesetzt wird,
- wobei durch das Montieren 33 der ersten Elektronikeinrichtung 25 die Kontaktierungseinheit 14 mit der Anschlusseinheit 13 verbunden wird,
- wobei die Anschlusseinheit 13 sich selbstzentrierend an die Position der Kontaktierungseinheit 14 anpasst 34.

Das dargestellte Verfahren weist den Vorteil auf, dass die Herstellung eines Messgeräts 1, insbesondere die Verbindung des elektrischen Durchführungselementes mit der Anschlusseinheit 13 besonders einfach ist, wodurch sowohl die Herstellung als auch ein Austauschen insbesondere der Baueinheit aus dem elektrischen Durchführungselement und der ersten Elektronikeinrichtung 25 besonders einfach ist.

### Bezugszeichen

- 1: Messgerät
- 2: Verfahren zur Herstellung eines Messgeräts
- 3: Sensor
- 4: Transmittergehäuse
- 5: Klemmenraum
- 6: Trennwand
- 7: Elektronikraum
- 8: Ausnehmung
- 9: Anschluss
- 10: Elektronik-Einsatz
- 11: zweite Elektronikeinrichtung
- 12: flexible Verbindung
- 13: Anschlusseinheit
- 14: Kontaktierungseinheit
- 15: Verbindungselemente
- 15a: Netzverbindungselemente
- 15b: Signalverbindungselemente
- 16: Schraubverbindung
- 17: sichere Verbindung
- 18: Isolierstoff
- 19: Schaltkreisgruppe
- 20: Metallisierungsschicht
- 21: Folie aus Flex Polyimid
- 22: Polyimid Schutzschicht
- 23: Schicht aus vorimpregnierten Fasern
- 24: Lötabdeckung
- 25: erste Elektronikeinrichtung
- 26: Klemme
- 27: Durchkontaktierung
- 28: Kontaktelement
- 28a: Netzanschlusselement
- 28b: Signalkontaktelement
- 29: Bohrung
- 30: Schlitz
- 31: Schutzkragen
- 32: Montieren der zweiten Elektronikeinrichtung
- 33: Montieren der ersten Elektronikeinrichtung
- 34: Anpassen an die Position der Kontaktierungseinheit

## Patentansprüche

1. Messgerät (1) mit wenigstens einem Sensor (3) und mit wenigstens einem Transmittergehäuse (4), wobei das Transmittergehäuse gemäß Anspruch 10 ausgestaltet ist.

2. Messgerät (1) nach Anspruch 1, **dadurch gekennzeichnet, dass** die Anschlusseinheit (13) zwischen den Netzverbindungselementen (15a) und den Signalverbindungselementen (15b) und/oder zwischen den Signalverbindungselementen (15b) untereinander und/oder zwischen den Netzverbindungselementen (15a) untereinander Mittel zur Vergrößerung des Abstandes, beispielsweise wenigstens eine Ausnehmung, insbesondere wenigstens eine Bohrung (29) und/oder wenigstens einen Schlitz (30) aufweist.

3. Messgerät (1) nach einem der Ansprüche 1 oder 2, **dadurch gekennzeichnet, dass** die Signalverbindungselemente (15b) kreisförmig in wenigstens einem Kreis um wenigstens ein Netzverbindungselement (15a) angeordnet sind.

4. Messgerät (1) nach einem der Ansprüche 1 bis 3, **dadurch gekennzeichnet, dass** die Signalverbindungselemente (15b) derart, vorzugsweise kreisförmig, um das wenigstens eine Netzverbindungselement (15a) angeordnet sind, dass der Abstand zwischen dem wenigstens einen Netzverbindungselement (15a) und den Signalverbindungselementen (15b) mindestens dem normierten Mindestabstand zur Einhaltung der Luft- und Kriechfestigkeit entspricht.

5. Messgerät (1) nach einem der Ansprüche 1 bis 4, **dadurch gekennzeichnet, dass** die Signalverbindungselemente (15b) zu wenigstens einer Schaltkreisgruppe (19) zusammengefasst sind, wobei die wenigstens eine Schaltkreisgruppe (19) wenigstens zwei Signalverbindungselemente (15b) aufweist.

6. Messgerät (1) nach Anspruch 5, **dadurch gekennzeichnet, dass** innerhalb wenigstens einer Schaltkreisgruppe (19) oder zwischen wenigstens zwei Schaltkreisgruppen (19) wenigstens ein Abstand zwischen zwei Signalverbindungselementen (15b) den normierten Mindestabstand zur Einhaltung der Luft- und Kriechfestigkeit unterschreitet.

7. Messgerät (1) nach einem der Ansprüche 1 bis 6, **dadurch gekennzeichnet, dass** die Anschlusseinheit (13) mit einem Isolierstoff abgedeckt ist.

8. Messgerät (1) nach einem der Ansprüche 1 bis 7, **dadurch gekennzeichnet, dass** die zumindest teilweise biegbare Leiterplatte wenigstens zwei starre Leiterplattenteile und wenigstens einen biegbaren Teil (12) aufweist, wobei der biegbare Teil (12) die wenigstens zwei starren Teile miteinander verbindet, wobei wenigstens ein starrer Teil als Anschlusseinheit (13) ausgestaltet ist und wobei wenigstens ein starrer Teil als Aufnahmeeinheit für die im Elektronikraum angeordnete Elektronik (10) ausgestaltet ist und wobei die Anschlusseinheit (13) und die Aufnahmeeinheit einen Winkel, vorzugsweise eine stumpfen Winkel oder einen spitzen Winkel oder einen 90°-Winkel, einschließen.

9. Messgerät (1) nach einem der Ansprüche 1 bis 8, **dadurch gekennzeichnet, dass** die biegbare Leiterplatte als mehrlagige Leiterplatte mit innenliegenden Leiterbahnen ausgestaltet ist.

10. Transmittergehäuse (4), wobei das Transmittergehäuse (4) wenigstens einen Klemmenraum (5) und einen zum Klemmenraum (5) benachbarten und über eine Trennwand (6) verbundenen Elektronikraum (7) aufweist, wobei in dem Klemmenraum (5) wenigstens eine erste Elektronikeinrichtung (25) für den Anschluss von Versorgungs- und/oder I/O-Leitungen angeordnet ist und wobei in dem Elektronikraum (7) wenigstens eine zweite Elektronikeinrichtung (11) mit Elektronik zur Steuerung des Sensors (3) angeordnet ist, wobei die erste Elektronikeinrichtung (25) und die zweite Elektronikeinrichtung (11) über eine Kontaktierungseinheit (14) miteinander elektrisch leitend verbunden sind,
wobei die zweite Elektronikeinrichtung (11) eine Anschlusseinheit (13) aufweist, die mit der Kontaktierungseinheit (14) über eine Steckverbindung verbunden ist, wobei die Steckverbindung eine Fügerichtung aufweist,
**dadurch gekennzeichnet,**
**dass** die Anschlusseinheit (13) in Fügerichtung fest angeordnet ist und dass die Anschlusseinheit (13) senkrecht zur Fügerichtung derart schwimmend angeordnet ist, dass sie sich bei der Verbindung mit der Kontaktierungseinheit (14) an die Position der Kontaktierungseinheit (14) anpasst, dass die Anschlusseinheit (13) Verbindungselemente (15) in Form von Netzverbindungselementen (15a) und/oder Signalverbindungselementen (15b) zur Übertragung elektrischer Signale aufweist und
**dass** die Verbindungselemente (15) zumindest teilweise als trichterförmige Buchsen ausgestaltet sind,
**dass** die zweite Elektronikeinrichtung (11) als zumindest teilweise biegbare Leiterplatte ausgestaltet ist und
**dass** das Transmittergehäuse (4) für die Verwendung in einem Messgerät (1) mit wenigstens einem Sensor (3) ausgestaltet ist.

11. Transmittergehäuse (4) nach Anspruch 10, **dadurch gekennzeichnet, dass** das Transmittergehäuse für die Verwendung in einem Messgerät gemäß einem der Patentansprüche 2 bis 9 ausgestaltet ist.

12. Verfahren (2) zur Herstellung eines Messgeräts (1), wobei das Messgerät (1) wenigstens einen Sensor (3) und wenigstens ein Transmittergehäuse (4) aufweist, wobei das Transmittergehäuse (4) wenigstens einen Klemmenraum (5) und einen zum Klemmenraum (5) benachbarten und über eine Trennwand (6) verbundenen Elektronikraum (7) aufweist, wobei in dem Klemmenraum (5) eine erste Elektronikeinrichtung (25) für den Anschluss von Versorgungs- und/oder I/O-Leitungen angeordnet ist und wobei in dem Elektronikraum (7) eine zweite Elektronikeinrichtung (11) mit Elektronik zur Steuerung des Sensors (3) angeordnet ist, wobei die in dem Elektronikraum (7) angeordnete zweite Elektronikeinrichtung (11) eine Anschlusseinheit (13) aufweist,
wobei eine Kontaktierungseinheit (14) vorhanden ist, die mit der ersten Elektronikeinrichtung (25) fest verbunden ist,
wobei die Kontaktierungseinheit (14) Kontaktelemente (28) in Form von Netzanschlusselementen (28a) und/oder Signalkontaktelementen (28b) zur Übertragung elektrischer Signale aufweist,
wobei die Anschlusseinheit (13) Verbindungselemente (15) in Form von Netzverbindungselementen (15a) und/oder Signalverbindungselementen (15b) aufweist, die Verbindungselemente (15) zumindest teilweise als trichterförmige Buchsen ausgestaltet sind,
wobei die zweite Elektronikeinrichtung (11) als zumindest teilweise biegbare Leiterplatte ausgestaltet ist,
und wobei das Verfahren (2) die folgenden Schritte umfasst:
- Montieren (32) der zweiten Elektronikeinrichtung (11) in dem Elektronikraum (7), wobei die Anschlusseinheit (13) schwimmend angeordnet wird,
- Montieren (33) der ersten Elektronikeinrichtung (25) in dem Klemmenraum (5), wobei die Kontaktierungseinheit (14) lösbar in die Trennwand eingesetzt wird,
- wobei durch das Montieren (33) der ersten Elektronikeinrichtung (25) die Kontaktierungseinheit (14) mit der Anschlusseinheit (13) verbunden wird,
- wobei die Anschlusseinheit (13) sich selbstzentrierend an die Position der Kontaktierungseinheit (14) anpasst (34).

## Claims

1. Measuring device (1) with at least one sensor (3) and with at least one transmitter housing (4),
wherein the transmitter housing is designed according to claim 10.

2. Measuring device (1) according to claim 1, **characterized in that** the terminal unit (13) between the network connecting elements (15a) and the signal connecting elements (15b) and/or between the signal connecting elements (15b) with one another and/or between the network connecting elements (15a) with one another has means for increasing the distance, for example at least one recess, in particular at least one bore hole (29) and/or at least one slot (30).

3. Measuring device (1) according to any one of claims 1 or 2, **characterized in that** the signal connecting elements (15b) are arranged in a circular manner in at least one circle around at least one network connecting element (15a).

4. Measuring device (1) according to any one of claims 1 to 3, **characterized in that** the signal connecting elements (15b) are arranged, preferably circularly, around the at least one network connecting element (15a) in such a way that the distance between the at least one network connecting element (15a) and the signal connecting elements (15b) corresponds at least to the standardized minimum distance for maintaining the air and creep resistance.

5. Measuring device (1) according to any one of claims 1 to 4, **characterized in that** the signal connecting elements (15b) are combined to form at least one circuit group (19), wherein the at least one circuit group (19) comprises at least two signal connecting elements (15b).

6. Measuring device (1) according to claim 5, **characterized in that** within at least one circuit group (19) or between at least two circuit groups (19) at least one distance between two signal connecting elements (15b) is less than the standardized minimum distance for compliance with the air and creep resistance.

7. Measuring device (1) according to any one of claims 1 to 6, **characterized in that** the connection unit (13) is covered with an insulating material.

8. Measuring device (1) according to any one of claims 1 to 7, **characterized in that** the at least partially bendable printed circuit board has at least two rigid printed circuit board parts and at least one bendable part (12), wherein the bendable part (12) connects the at least two rigid parts to one another, wherein at least one rigid part is designed as a terminal unit (13) and wherein at least one rigid part is designed as a receiving unit for the electronics (10) arranged in the electronics compartment and wherein the terminal unit (13) and the receiving unit enclose an angle, preferably an obtuse angle or an acute angle or a 90° angle.

9. Measuring device (1) according to any one of claims 1 to 8, **characterized in that** the bendable printed circuit board is designed as a multilayer printed circuit board with internal conductor tracks.

10. Transmitter housing (4), wherein the transmitter housing (4) has at least one terminal space (5) and an electronics space (7) adjacent to the terminal space (5) and connected via a partition wall (6), wherein at least one first electronic device (25) for the connection of supply and/or I/O lines is arranged in the terminal space (5) and wherein at least one second electronic device (11) with electronics for controlling the sensor (3) is arranged in the electronic space (7), wherein the first electronic device (25) and the second electronic device (11) are electrically conductively connected to one another via a contacting unit (14),
wherein the second electronic device (11) has a terminal unit (13) which is connected to the contacting unit (14) via a plug connection, wherein the plug connection has a joining direction,
**characterized in**
**that** the terminal unit (13) is arranged fixed in the joining direction and that the terminal unit (13) is arranged floating perpendicular to the joining direction in such a way that it adapts to the position of the contacting unit (14) when connected to the contacting unit (14), that the terminal unit (13) has connecting elements (15) in the form of network connecting elements (15a) and/or signal connecting elements (15b) for transmitting electrical signals, and
**that** the connecting elements (15) are at least partially designed as funnel-shaped sockets,
**that** the second electronic device (11) is designed as an at least partially bendable printed circuit board, and
**that** the transmitter housing (4) is designed for use in a measuring device (1) with at least one sensor (3).

11. Transmitter housing (4) according to claim 10, **characterized in that** the transmitter housing is designed for use in a measuring device according to any one of claims 2 to 9.

12. Method (2) for producing a measuring device (1), wherein the measuring device (1) has at least one sensor (3) and at least one transmitter housing (4), wherein the transmitter housing (4) has at least one terminal space (5) and an electronics space (7) adjacent to the terminal space (5) and connected via a partition wall (6), wherein a first electronic device (25) for the connecting of supply and/or I/O lines is arranged in the terminal space (5) and wherein a second electronic device (11) with electronics for controlling the sensor (3) is arranged in the electronic space (7), wherein the second electronic device (11) arranged in the electronic space (7) has a terminal unit (13),
wherein a contacting unit (14) is present, which is permanently connected to the first electronic device (25),
wherein the contacting unit (14) has contact elements (28) in the form of mains connection elements (28a) and/or signal contact elements (28b) for transmitting electrical signals,
wherein the terminal unit (13) has connecting elements (15) in the form of mains connecting elements (15a) and/or signal connecting elements (15b), the connecting elements (15) being designed at least partially as funnel-shaped sockets,
wherein the second electronic device (11) is designed as an at least partially bendable printed circuit board,
and wherein the method (2) comprises the following steps:
- installing (32) the second electronics device (11) in the electronics compartment (7), wherein the terminal unit (13) is arranged in a floating manner,
- installing (33) the first electronic device (25) in the terminal space (5), wherein the contacting unit (14) is detachably inserted into the partition wall,
- wherein the contacting unit (14) is connected to the terminal unit (13) by installing (33) the first electronic device (25),
- wherein the terminal unit (13) adapts (34) by self-centering to the position of the contacting unit (14).

## Revendications

1. Appareil de mesure (1) comprenant au moins un capteur (3) et au moins un boîtier de transmetteur (4), le boîtier de transmetteur étant conçu selon la revendication 10.

2. Appareil de mesure (1) selon la revendication 1, **caractérisé en ce que** l'unité de raccordement (13) comporte entre les éléments de liaison côté réseau (15a) et les éléments de liaison côté signal (15b) et/ou entre les éléments de liaison côté signal (15b) entre eux et/ou entre les éléments de liaison côté réseau (15a) entre eux des moyens destinés à augmenter la distance, par exemple au moins un évidement, notamment au moins un alésage (29) et/ou au moins une fente (30).

3. Appareil de mesure (1) selon l'une des revendications 1 ou 2, **caractérisé en ce que** les éléments de liaison côté signal (15b) sont disposés circulairement suivant au moins un cercle autour d'au moins un élément de liaison côté réseau (15a).

4. Appareil de mesure (1) selon l'une des revendications 1 à 3, **caractérisé en ce que** les éléments de liaison côté signal (15b) sont disposés, de préférence suivant un cercle, autour de l'au moins un élément de liaison côté réseau (15a) de telle sorte que la distance entre l'au moins un élément de liaison côté réseau (15a) et les éléments de liaison côté signal (15b) correspondent à au moins la distance minimale normalisée pour maintenir la résistance à l'air et au fluage.

5. Appareil de mesure (1) selon l'une des revendications 1 à 4, **caractérisé en ce que** les éléments de liaison côté signal (15b) sont réunis pour former au moins un groupe de circuits (19), l'au moins un groupe de circuits (19) comportant au moins deux éléments de liaison côté signal (15b).

6. Appareil de mesure (1) selon la revendication 5, **caractérisé en ce que**, à l'intérieur d'au moins un groupe de circuits (19) ou entre au moins deux groupes de circuits (19), au moins une distance entre deux éléments de liaison côté signal (15b) est inférieure à la distance minimale normalisée pour maintenir la résistance à l'air et au fluage.

7. Appareil de mesure (1) selon l'une des revendications 1 à 6, **caractérisé en ce que** l'unité de raccordement (13) est recouverte d'un matériau isolant.

8. Appareil de mesure (1) selon l'une des revendications 1 à 7, **caractérisé en ce que** le circuit imprimé au moins partiellement flexible comporte au moins deux parties de circuit imprimé rigides et au moins une partie flexible (12), la partie flexible (12) reliant les au moins deux parties rigides entre elles, au moins une partie rigide étant conçue comme une unité de raccordement (13) et au moins une partie rigide étant conçue comme une unité de réception de l'électronique (10) disposée dans le compartiment d'électronique et l'unité de raccordement (13) et l'unité de réception formant un angle, de préférence un angle obtus ou un angle aigu ou un angle de 90°.

9. Appareil de mesure (1) selon l'une des revendications 1 à 8, **caractérisé en ce que** le circuit imprimé flexible est conçu comme un circuit imprimé multicouche pourvu de pistes conductrices intérieures.

10. Boîtier du transmetteur (4), le boîtier de transmetteur (4) comportant au moins un compartiment de bornes (5) et un compartiment d'électronique (7) adjacent au compartiment de bornes (5) et relié par le biais d'une paroi de séparation (6), au moins un premier module d'électronique (25) destiné au raccordement de lignes d'alimentation et/ou de lignes d'Entrée/Sortie étant disposé dans le comportant de bornes (5) et au moins un deuxième module d'électronique (11) pourvu de l'électronique de commande du capteur (3) étant disposé dans le compartiment d'électronique (7), le premier module électronique (25) et le deuxième module électronique (11) étant reliés électriquement l'un à l'autre par le biais d'une unité de contact (14), le deuxième module d'électronique (11) comportant une unité de raccordement (13) qui est reliée à l'unité de contact (14) par le biais d'une liaison par enfichage, la liaison par enfichage présentant une direction d'assemblage,
**caractérisé en ce que**
l'unité de raccordement (13) est disposée de manière fixe dans la direction d'assemblage et
l'unité de raccordement (13) est disposée de manière flottante perpendiculairement à la direction d'assemblage de telle sorte qu'elle s'adapte à la position de l'unité de contact (14) lorsqu'elle est reliée à l'unité de contact (14),
l'unité de raccordement (13) comporte des éléments de liaison (15) se présentant sous la forme d'éléments de liaison côté réseau (15a) et/ou d'éléments de liaison côté signal (15b) pour transmettre des signaux électriques et
les éléments de liaison (15) sont au moins partiellement réalisés sous la forme de douilles en forme d'entonnoir,
le deuxième module d'électronique (11) est conçu comme une carte de circuit imprimé au moins partiellement flexible et
le boîtier de transmetteur (4) est conçu pour être utilisé dans un appareil de mesure (1) pourvu d'au moins un capteur (3).

11. Boîtier de transmetteur (4) selon la revendication 10, **caractérisé en ce que** le boîtier de transmetteur est conçu pour être utilisé dans un appareil de mesure selon l'une des revendications 2 à 9.

12. Procédé (2) de fabrication d'un appareil de mesure (1), l'appareil de mesure (1) comportant au moins un capteur (3) et au moins un boîtier de transmetteur (4), le boîtier de transmetteur (4) comportant au moins un compartiment de bornes (5) et un compartiment d'électronique (7) adjacent au compartiment de bornes (5) et relié par le biais d'une paroi de séparation (6), un premier module d'électronique (25) étant disposé dans le compartiment de bornes (5) pour la liaison de lignes d'alimentation et/ou de lignes d'Entrée/Sortie et un deuxième module d'électronique (11) pourvu d'une électronique de commande du capteur (3) est disposé dans le compartiment d'électronique (7), le deuxième appareil électronique (11) disposé dans le compartiment d'électronique (7) comportant une unité de raccordement (13),
une unité de contact (14) étant prévue qui est rliée de manière fixe au premier module d'électronique (25), l'unité de contact (14) comportant des éléments de contact (28) se présentant sous la forme d'éléments de raccordement côté réseau (28a) et/ou d'éléments de contact de signal (28b) pour transmettre des signaux électriques,
l'unité de raccordement (13) comportant des éléments de liaison (15) se présentant sous la forme d'éléments de liaison côté réseau (15a) et/ou d'éléments de liaison côté signal (15b), les éléments de liaison (15) étant au moins partiellement conçus sous la forme de douilles en forme d'entonnoir,
le deuxième module d'électronique (11) étant conçu sous la forme d'une carte de circuit imprimé au moins partiellement flexible, et
le procédé (2) comprenant les étapes suivantes :
- monter (32) le deuxième module d'électronique (11) dans le compartiment d'électronique (7), l'unité de raccordement (13) étant disposée de manière flottante,
- monter (33) le premier module d'électronique (25) dans le compartiment de bornes (5), l'unité de contact (14) étant insérée de manière amovible dans la paroi de séparation,
- l'unité de contact (14) étant reliée à l'unité de raccordement (13) par le montage (33) du premier module d'électronique (25),
- l'unité de raccordement (13) s'adaptant (34) à la position de l'unité de contact (14) de manière autocentrée.
